# EUROPÄISCHE PATENTSCHRIFT

(11) **EP 3 186 828 B1**
(45) Veröffentlichungstag und Bekanntmachung des Hinweises auf die Patenterteilung: **11.09.2019**
(21) Anmeldenummer: 15738019.7
(22) Anmeldetag: 08.07.2015
(51) Int. Cl.: H05K 5/00, H01L 23/24, H01L 23/057

(54) **MODULANORDNUNG SOWIE GETRIEBESTEUERMODUL**
MODULE ASSEMBLY AND TRANSMISSION CONTROL MODULE
ENSEMBLE DE MODULE ET MODULE DE COMMANDE DE BOÎTE DE VITESSES

(30) Priorität: 29.08.2014 DE 102014217351
(43) Veröffentlichungstag der Anmeldung: 05.07.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2015/065577
(87) Internationale Veröffentlichungsnummer: WO 2016/030067

(56) Entgegenhaltungen:
- US-A- 5 324 888
- US-A- 5 650 593
- US-A- 5 767 447
- US-A1- 2012 240 396
- US-A1- 2013 314 878
- Anonymous: "Section 8. Rubber solutions A-Z. Facts and figures about silicone", Solid liquid silcione rubber material processing guidelines , Juni 2015 (2015-06), Seite 84, XP002744985, Gefunden im Internet: URL:http://www.wacker.com/cms/media/public ations/downloads/6709_EN.pdf [gefunden am 2015-09-24]

## Beschreibung

### Gebiet der Erfindung

Die Erfindung betrifft eine Modulanordnung für ein Getriebesteuermodul sowie ein Getriebesteuermodul für ein Kraftfahrzeug.

### Hintergrund der Erfindung

Zur Steuerung von Getrieben, insbesondere Automatikgetrieben, in einem Kraftfahrzeug werden elektronische Getriebesteuermodule verwendet, die entweder im Inneren eines Getriebegehäuses als integrierte Module angeordnet sind oder von außen als Anbaumodule an das Getriebegehäuse montiert werden.

Integrierte Getriebesteuermodule weisen in der Regel eine Modulanordnung mit einer elektronischen Schaltung ("transmission control unit", TCU), wenigstens einen Sensor, mindestens eine Steckverbindung zum Anschluss an einen Fahrzeugkabelbaum und elektrische Schnittstellen zum Ansteuern von Aktuatoren auf.

Die elektronischen Schaltungen der Modulanordnungen können dabei diverse Bauelemente aufweisen, insbesondere Kondensatoren, Speicher, Leistungsendstufen, Widerstände und/oder Halbleiterchips. Unter anderem aufgrund von Bauraumbeschränkungen werden für Halbleiterbauelemente sogenannte "Bare-Die-Bauelemente", d.h. ungehäuste Silizium-Bauelemente, eingesetzt.

Eine Systemkomponente für ein derartiges Getriebesteuermodul ist in der DE 10 2005 003 448 A1 offenbart. Weitere Modulanordnungen sind beispielsweise in US5324888, US5767447 und US5650593 gezeigt.

### Offenbarung der Erfindung

Die gegenwärtige Erfindung besteht in einer Modulanordnung gemäß dem Gegenstand des Anspruchs 1.

Ausführungsformen der vorliegenden Erfindung können in vorteilhafter Weise ermöglichen, eine kostengünstig produzierbare und robuste Modulanordnung für ein Getriebesteuermodul sowie ein entsprechendes Getriebesteuermodul bereitzustellen.

Gemäß einem Aspekt der Erfindung wird eine Modulanordnung für ein Getriebesteuermodul vorgeschlagen, welche eine Substratplatte mit einer elektronischen Schaltung aufweist, die auf einer Montageseite der Substratplatte angeordnet ist und wenigstens ein ungehäustes und mit freiliegenden Bonddrähten kontaktiertes Halbleiterbauelement aufweist. Die erfindungsgemäße Modulanordnung zeichnet sich insbesondere dadurch aus, dass die Modulanordnung ferner einen Kontaktrahmen aufweist, der die elektronische Schaltung an der Montageseite der Substratplatte ringförmig umläuft, und dass die elektronische Schaltung vollständig mit einer Schutzmasse insbesondere zum Schutz der Bonddrähte des Halbleiterbauelements vergossen ist.

Das ungehäuste Halbleiterbauelement, wie etwa ein Halbleiterchip, sowie die freiliegenden Bonddrähte können empfindlich gegenüber beispielsweise Verunreinigungen, Feuchte und/oder durch Fremdpartikel hervorgerufene Kurzschlüsse sein. Durch die erfindungsgemäße Modulanordnung, bei welcher Bauelemente der elektronischen Schaltung mit der Schutzmasse vergossen sind, kann ein umfassender, zuverlässiger, dauerhafter und kostengünstiger Schutz der Bauelemente gewährleistet sein. So können die Modulanordnungen beispielsweise in einem Werk zentral produziert und transportsicher durch die Schutzmasse geschützt werden, um anschließend zu einem weiteren Werk transportiert und dort in einem Getriebesteuermodul verbaut zu werden. Die zentrale Fertigung der Modulanordnungen kann mit einer Kostenoptimierung, etwa aufgrund von Stückzahleffekten für eine teure Fertigung unter Reinraumbedingungen, verbunden sein. Auch kann eine derartige Fertigung mit einer Kostenreduktion durch Entfall von Bauteilen, wie etwa einer speziellen Transportverpackung für die Modulanordnung, verbunden sein. Auch kann sich ein Kostenvorteil durch lokale Fertigung weiterer Komponenten der Getriebesteuermodule und einen lokalen Zusammenbau des Getriebesteuermoduls ergeben.

Ideen zu Ausführungsformen der vorliegenden Erfindung können unter anderem als auf den nachfolgend beschriebenen Gedanken und Erkenntnissen beruhend angesehen werden. Elektronische Schaltungen mit ungehäusten Halbleiterbauelementen können freiliegende Bonddrähte mit einem Durchmesser von wenigen zehn µm aufweisen. Auch sogenannte Pitch-Abstände von Bauelementen der elektronischen Schaltungen können verhältnismäßig klein sein. Typischerweise weist eine elektronische Schaltung für ein Getriebesteuermodul einen mittleren Pitch-Abstand von rund 45 nm bis 90 nm auf. Derartige elektronische Schaltungen können daher äußerst empfindlich gegenüber Verunreinigungen sowie etwa durch leitende, auch sehr kleine Fremdpartikel hervorgerufene Kurzschlüsse sein. Deshalb werden bisher mit einer derartigen elektronischen Schaltung bestückte Substratplatten häufig aufwändig in ein hermetisch dichtes Gehäuse verpackt und auf diese Weise geschützt. Als Alternative können die bestückten Substratplatten auch in einem speziellen Gussgehäuse vergossen werden (Mold-TCU). Für eine Bestückung von Substratplatten mit ungehäusten Halbleiterbauelementen ist meist ein aufwendiges Produktionswerk mit Reinraum nötig, was mit erheblichen Investitionen verbunden sein kann. Fertig bestückte und in ein hermetisch dichtes Gehäuse integrierte bzw. vergossene Substratplatten werden dann an andere Standorte geliefert, in denen Getriebesteuermodule hergestellt werden. Dadurch kann ein teurer Fertigungsverbund entstehen und dementsprechend können Getriebesteuermodule verhältnismäßig teuer sein. Durch die erfindungsgemäße Ausgestaltung der Modulanordnung sowie den kostengünstigen Schutz der elektronischen Schaltung mit Schutzmasse können die Modulanordnungen in wenigen spezialisierten Werken gefertigt werden, ohne dass ein teures Gehäuse, wie etwa ein Stahlgehäuse und/oder ein Gussgehäuse nötig wäre. Eine Fertigung weiterer Komponenten des Getriebesteuermoduls kann dagegen vor Ort in den Ländern der jeweiligen Kunden erfolgen. Durch den Schutz der elektronischen Schaltungen mit Schutzmasse können die Modulanordnungen so an andere Werke verschickt werden, ohne dass hohe finanzielle Aufwendungen erbracht werden müssen, um Feuchte, Umweltstoffe und vor allem Fremdpartikel von den elektronischen Schaltungen der Modulanordnungen fernzuhalten. Mit anderen Worten kann auf eine teure und aufwendige Verpackung der Modulanordnungen für den Transport von einem Werk in ein weiteres Werk verzichtet werden, ohne dass Fremdpartikel, Feuchte oder andere Umwelteinflüsse zum einen Bauelement der elektronischen Schaltung oder zum anderen beispielsweise elektrische Kontaktstellen (z. B. Bondflächen) der elektronischen Schaltungen etwa für eine Integration in ein Getriebesteuermodul schädigen könnten.

Gemäß einer Ausführungsform der Erfindung ist die Schutzmasse in einem ungehärteten Zustand ausreichend fließfähig, um freiliegende Bonddrähte schädigungsfrei zu umfließen. Mit anderen Worten kann die Schutzmasse in dem ungehärteten Zustand einen ausreichend kleinen Viskositätswert aufweisen, so dass die freiliegenden Bonddrähte und weitere Bauelemente der elektronischen Schaltung vollständig vergossen werden können, ohne dass beispielsweise die Bonddrähte durch einen Fließwiderstand der Schutzmasse abgeknickt und/oder verbogen werden.

Gemäß der Erfindung weist die Modulanordnung einen Kontaktpin zur elektrischen Kontaktierung der elektronischen Schaltung auf, wobei der Kontaktpin seitlich von der Substratplatte abragt. Der Kontaktpin kann dabei derart von der Substratplatte abragen, dass er zumindest an einer Kontaktstelle nicht von der Schutzmasse benetzt und elektrisch isoliert wird. Dadurch kann ein zuverlässiger elektrischer Kontakt zwischen Kontaktpin und weiteren Komponenten sichergestellt sein.

Gemäß der Erfindung stellt der die elektronische Schaltung ringförmig umlaufende Kontaktrahmen eine Einfassung für die elektronische Schaltung bereit, so dass ein von der Einfassung umschlossener Bereich der Montageseite mit der Schutzmasse füllbar ist. Der Kontaktrahmen kann dabei dicht an der Substratplatte anliegend ausgestaltet sein, so dass die Schutzmasse gezielt in den von der Einfassung umschlossenen Bereich gefüllt werden kann und nicht etwa seitlich aus der Modulanordnung abfließen kann. Dadurch kann ferner sichergestellt werden, dass die elektronische Schaltung bis zu einer gewissen Höhe über einer Oberfläche der Substratplatte mit Schutzmasse bedeckt werden kann und sämtliche Bauelemente der elektronischen Schaltung vollständig mit Schutzmasse bedeckt sein können.

Gemäß einer Ausführungsform der Erfindung ist die Schutzmasse ein Silikongel und/oder ein Schutzlack. Beispielsweise kann die Schutzmasse ein zweikomponentiges Silikongel sein, welches in einem ungehärteten Zustand mit geringer Viskosität aufgebracht werden kann und anschließend thermisch, chemisch und/oder trocknend ausgehärtet werden kann. Auch kann ein fließfähiger Schutzlack beispielsweise aufgesprüht und anschließend ausgehärtet werden.

Gemäß einer Ausführungsform der Erfindung weist die Schutzmasse eine spezifische Dichte in einem Bereich von 0,5 g/cm³ bis 2 g/cm³ auf. Durch eine verhältnismäßig geringe spezifische Dichte kann sichergestellt sein, dass etwa die Bonddrähte (spezifische Dichte bei z. B. Aluminium 2,7 g/cm³) nicht bedingt durch eine Gewichtskraft der darauf befindlichen Schutzmasse beschädigt werden.

Gemäß einer Ausführungsform der Erfindung ist die Schutzmasse thermisch härtend. Durch eine thermische Aushärtung der Schutzmasse kann in vorteilhafter Weise eine Aushärtedauer der Schutzmasse gesteuert und so ein Fertigungsprozess optimiert werden.

Gemäß einer Ausführungsform der Erfindung weist die die Schutzmasse in einem ungehärteten Zustand eine Viskosität von maximal 50 Pa s auf. Typische Werte liegen im Bereich von 10 Pa s. Dadurch kann sichergestellt sein, dass sämtliche Bauelemente der elektronischen Schaltung vollständig von der Schutzmasse umflossen werden. Auch kann ein Fertigungsprozess durch eine im ungehärteten Zustand niedrigviskose Schutzmasse beschleunigt werden.

Gemäß einer Ausführungsform der Erfindung weist der Kontaktrahmen ein Positionierelement auf, welches an einer Seitenfläche der Substratplatte anliegt. So kann in vorteilhafter Weise sichergestellt sein, dass der Kontaktrahmen an einer vorgesehenen Position der Substratplatte angeordnet und dichtend auf dieser aufliegen kann.

Gemäß einer Ausführungsform der Erfindung weist der Kontaktrahmen wenigstens einen die elektronische Schaltung zumindest bereichsweise überdeckenden Querriegel auf, welcher an einer Seite des Kontaktrahmens angeordnet ist, die der an der Montageseite anliegenden Seite des Kontaktrahmens entgegengesetzt angeordnet ist. Der Querriegel kann als Berührschutz für die darunter liegende elektronische Schaltung dienen und so einen zusätzlichen Schutz bieten. Auch können dadurch mehrere Modulanordnungen beschädigungsfrei aufeinander gestapelt und transportiert werden.

Ein weiterer Aspekt der Erfindung betrifft ein Getriebesteuermodul mit einer Modulanordnung wie obenstehend und untenstehend beschrieben, welche in eine die Modulanordnung umschließende Modulleiterplatte integriert und mit der Modulleiterplatte elektrisch verbunden ist. Die Modulleiterplatte kann dazu eine Vertiefung und/oder eine Ausnehmung aufweisen, in welche die Modulanordnung einsetzbar sein kann. Die Modulanordnung kann weiter, beispielsweise mit dem Kontaktpin, mit einem Kontaktplättchen der Modulleiterplatte elektrisch kontaktiert werden.

Gemäß einer Ausführungsform der Erfindung ist die Modulanordnung mit einer der Montageseite entgegengesetzt angeordneten Seite der Substratplatte auf einer Getriebesteuermodulgrundplatte fixiert. Weiter weist das Getriebesteuermodul einen Schutzdeckel auf, welcher die Modulanordnung an einer der Getriebesteuermodulgrundplatte gegenüberliegenden Seite vollständig umschließt. Die Getriebesteuermodulgrundplatte kann beispielsweise einen Kühlkörper zur Kühlung der Modulanordnung bereitstellen und/oder aufweisen. Durch den Schutzdeckel können die Modulanordnung und insbesondere die elektronische Schaltung zuverlässig und dauerhaft vor in einem Getriebe vorhandenen Medien geschützt werden, so dass eine Lebensdauer des Getriebesteuermoduls erhöht sein kann.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1A und 1B zeigen eine Draufsicht und ein Schnittbild einer Modulanordnung gemäß einer Ausführungsform der Erfindung.
Fig. 2A und 2B zeigen eine Draufsicht und ein Schnittbild einer Modulanordnung gemäß einer weiteren Ausführungsform der Erfindung.
Fig. 3A und 3B zeigen jeweils ein Schnittbild eines Getriebesteuermoduls gemäß Ausführungsformen der Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

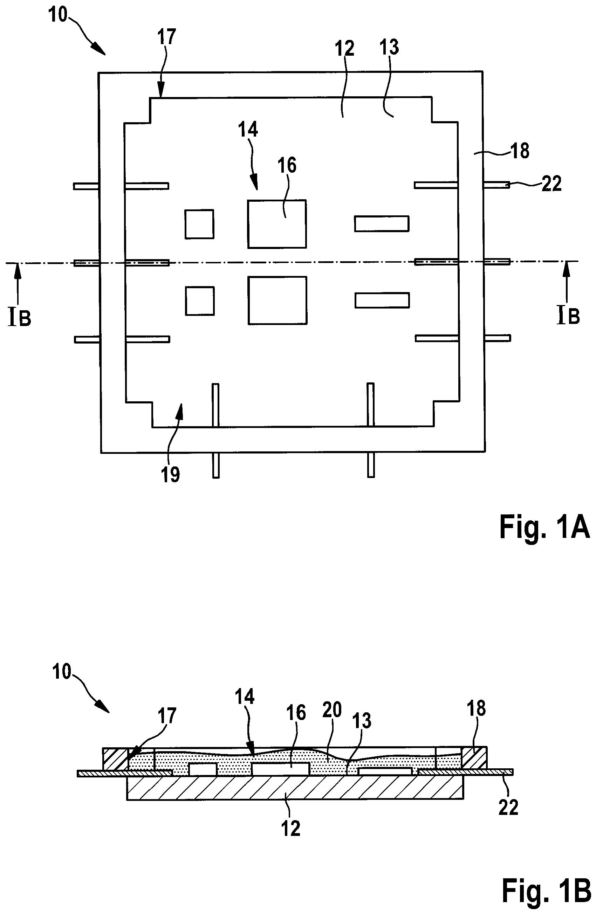

Fig. 1A und 1B zeigen eine Draufsicht (Fig. 1A) und ein Schnittbild (Fig. 1B) einer Modulanordnung 10 gemäß einer Ausführungsform der Erfindung, wobei der Schnitt in Fig. 1B entlang der Linie IB-IB aus Fig. 1A verläuft.

Die Modulanordnung 10 weist eine Substratplatte 12 mit einer Montageseite 13 auf, auf welcher Bauelemente einer elektronischen Schaltung 14 angeordnet sind. Die Substratplatte 12 kann zumindest teilweise beispielsweise aus Keramikmaterial, etwa in Form einer LTCC-Substratplatte ("low temperature cofired ceramics", LTCC), gefertigt sein und/oder etwa als HDI-Leiterplatte ("high density interconnect", HDI) ausgestaltet sein. Die Substratplatte 12 kann somit als Schaltungsträger erachtet werden.

Die elektronische Schaltung 14 weist wenigstens ein ungehäustes Halbleiterbauelement 16 auf, etwa ein ungehäustes Silizium-Bauelement, welches im sogenannten "Bare-Die-Verfahren" auf die Montageseite 13 der Substratplatte 12 montiert ist. Das Halbleiterbauelement 16 ist mit freiliegenden Bonddrähten kontaktiert und in die elektronische Schaltung 14 integriert.

Weiter weist die Modulanordnung 10 einen Kontaktrahmen 18 auf, welcher zumindest teilweise auf der Montageseite 13 der Substratplatte 12 angeordnet ist und/oder auf dieser aufliegt. Erfindungsgemäß ist der Kontaktrahmen 18 mit der Montageseite verlötet. Der Kontaktrahmen 18 umläuft bzw. umschließt die elektronische Schaltung 14 ringförmig. Mit anderen Worten liegt der Kontaktrahmen 18 in einem Randbereich der Montageseite 13 an jeder Außenkante der Montageseite 13 bzw. an entsprechenden Außenkanten der Substratplatte 12 an, so dass durch den Kontaktrahmen 18 eine um die elektronische Schaltung 16 und/oder einen Bereich 19 der Montageseite 13 umlaufende Einfassung 17 ausgebildet ist. Der Kontaktrahmen 18 kann dabei dichtend auf dem Randbereich der Montageseite 13 aufliegen. Der Kontaktrahmen 18 kann ferner bündig mit Seitenflächen der Substratplatte 12 abschließen oder teilweise über die Substratplatte 12 hinausragen. Auch ist denkbar, dass der Kontaktrahmen 18 auf dem Randbereich der Montageseite 13 aufliegt und von Außenkanten der Substratplatte 12 in lateraler Richtung beabstandet ist. Der Kontaktrahmen 18 ist aus Kunststoff gefertigt, beispielsweise aus Duroplast, PPS und/oder PPA und weist einen thermischen Expansionskoeffizienten auf, welcher möglichst nahe einem Koeffizienten der Substratplatte 12, etwa nahe eines PCB-Basismaterials ("printed circuit board", PCB), ist.

Der von der durch den Kontaktrahmen 18 ausgebildeten Einfassung 17 umschlossene Bereich 19 der Montageseite 13 ist ferner mit einer Schutzmasse 20 bedeckt, so dass die elektronische Schaltung 14 und insbesondere die Bonddrähte des Halbleiterbauelements 16 vollständig mit der Schutzmasse 20 vergossen sind. Die Schutzmasse 20 bedeckt alle im Bereich 19 liegenden Bauteile (Elektronik, Bonddrähte, Substratplatte 12, etc.) wenigstens mit einer Höhe von 0,5 mm. Weiter kann der Bereich 19 soweit mit der Schutzmasse 20 aufgefüllt sein, dass die Füllhöhe nie die Höhe des Kontaktrahmens 18 übersteigt und nicht die Unterseite des Querriegels 30 berührt. Der Bereich 19 kann somit bis zu einer Außenkante des Kontaktrahmens 18 mit der Schutzmasse 20 gefüllt sein.

Die Schutzmasse 20 ist insbesondere dazu vorgesehen, um Bauelemente der elektronischen Schaltung 14 vor Fremdpartikeln, Feuchte und/oder anderen Umwelteinflüssen zu schützen. Insbesondere ist die Schutzmasse 20 dazu ausgelegt, die freiliegenden Bonddrähte vor einem Abknicken zu schützen, d.h. diese zu stabilisieren, und/oder einen Kurzschluss durch einen Fremdpartikel zwischen zwei oder mehreren Bonddrähte zu vermeiden. Da die feinsten Bonddrähte in der Regel einen Durchmesser im Bereich weniger zehn µm aufweisen, beispielsweise 20 µm bis 50 µm, ist die Schutzmasse 20 in einem ungehärteten Zustand, in dem sie auf die Substratplatte 12 aufgebracht wird, fließfähig, so dass die Bonddrähte schädigungsfrei umflossen werden können. Beispielsweise kann die Schutzmasse 20 zu diesem Zweck eine spezifische Dichte in einem Bereich von 0,5 g/cm³ bis 2 g/cm³ sowie in dem ungehärteten Zustand eine Viskosität von maximal 50 Pa s aufweisen. Die Schutzmasse 20 kann beispielsweise ein Silikongel oder ein Schutzlack sein. Auch kann die Schutzmasse 20 mehrkomponentig sein, etwa ein Zwei-Komponenten-Silikongel, wobei in diesem Fall die maximale Viskosität eine mittlere maximale Viskosität ist und die spezifische Dichte eine mittlere spezifische Dichte ist. Die Schutzmasse 20 kann thermisch-härtend, chemisch-härtend und/oder trocknungs-härtend sein. Beispielsweise kann die Schutzmasse 20 derart gewählt sein, dass sie in einem fließfähigen Zustand auf die Substratplatte 12 aufgebracht werden kann und dann bei einer Temperatur in einem Bereich zwischen 50° C und 150°C innerhalb einiger Minuten, etwa 2 bis 30 Minuten, ausgehärtet werden kann, so dass ein Fertigungsprozess effizient gestaltet werden kann.

Des Weiteren weist die Modulanordnung 10 Kontaktpins 22 zur Kontaktierung der elektronischen Schaltung 14 auf. Die Kontaktpins 22 können zumindest in einem Teilbereich zwischen dem Kontaktrahmen 18 und der Substratplatte 12 angeordnet sein. Die Kontaktpins 22 sind mit einem ersten Ende mit der elektronischen Schaltung 14 verbunden und ragen mit einem zweiten Ende seitlich von der Substratplatte 12 ab. Die Kontaktpins 22 können durch Ausnehmungen und/oder Öffnungen in dem Kontaktrahmen 18 geführt sein und formschlüssig darin aufgenommen sein, so dass der Kontaktrahmen 18 dichtend auf der Montageseite 13 aufliegen kann. Die Kontaktpins 22 können beispielsweise aus Cu, Ag und/oder einem leitfähigen Kunststoff ausgebildet sein. Die Kontaktpins 22 können integral oder mehrteilig mit dem Kontaktrahmen 18 ausgebildet sein.

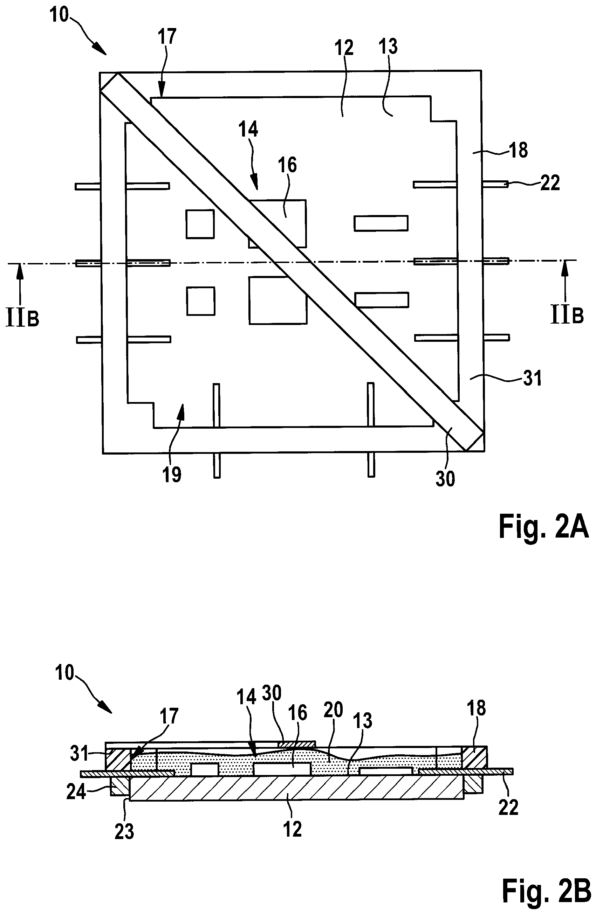

Fig. 2A und 2B zeigen eine Draufsicht (Fig. 2A) und ein Schnittbild (Fig. 2B) einer Modulanordnung 10 gemäß einer weiteren Ausführungsform der Erfindung, wobei der Schnitt in Fig. 2B entlang der Linie IIB-IIB aus Fig. 2A verläuft. Sofern nicht anders beschrieben kann die Modulanordnung 10 der Fig. 2A und Fig. 2B dieselben Elemente und Merkmale aufweisen wie die Modulanordnung 10 der Fig. 1A und 1B.

Der Kontaktrahmen 18 weist ein Positionierelement 24 auf, welches an einer Seitenfläche 23 der Substratplatte 12 anliegt und dazu ausgeführt ist, den Kontaktrahmen 18 auf der Substratplatte 12 zu positionieren und/oder zu fixieren. Das Positionierelement 24 kann beispielsweise als Abragung oder als um die Substratplatte 12 zumindest teilweise umlaufende Rahmenstruktur ausgebildet sein.

Weiter weist die Modulanordnung 10 der Fig. 2A und 2B einen Querriegel 30 auf, welcher die elektronische Schaltung 14 zumindest bereichsweise überdeckt und als Berührschutz für die elektronische Schaltung 14 und/oder die Schutzmasse 20 dient. Der Querriegel 30 ist dabei an einer Seite 31 des Kontaktrahmens 18 angeordnet, die einer an der Montageseite 13 anliegenden Seite des Kontaktrahmens 18 entgegengesetzt angeordnet ist. Der Querriegel 30 kann die Montageseite 13 der Substratplatte bzw. den Bereich 19 dabei diagonal oder parallel zu einer Außenkante der Substratplatte 12 überspannen. Die Modulanordnung kann auch mehrere derartige Querriegel 30 aufweisen. Der Querriegel 30 kann integral mit dem Kontaktrahmen 18 ausgebildet sein oder als separates Bauelement auf diesem befestigt, beispielsweise geklebt, gelötet oder geschweißt, sein. Der Querriegel 30 kann auch dazu ausgeführt sein, dass mehrere Modulanordnungen 10 beispielsweise für einen Transport aufeinander stapelbar sind.

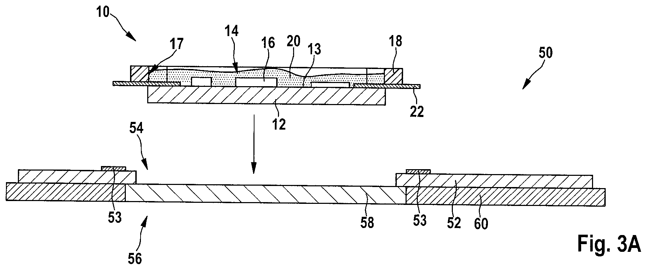

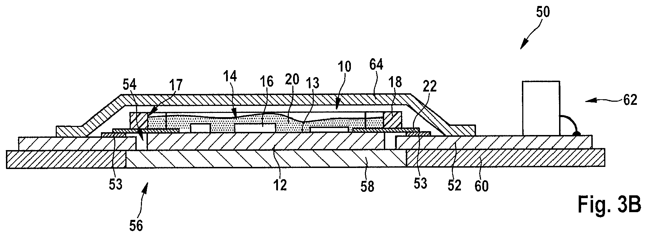

Fig. 3A und 3B zeigen jeweils ein Schnittbild eines Getriebesteuermoduls 50 gemäß Ausführungsformen der Erfindung.

Das Getriebesteuermodul 50 weist eine Getriebesteuermodulgrundplatte 56 auf, auf der eine Modulleiterplatte 52 mit einer Ausnehmung 54 bzw. Aussparung aufgebracht ist, in welche die Modulanordnung 10 einsetzbar ist, so dass die Modulleiterplatte 52 die Modulanordnung 10 im Wesentlichen umschließt. Die Modulleiterplatte 52 kann etwa eine PCB-Platte und/oder eine Flexfolie zur elektrischen Kontaktierung von Komponenten des Getriebesteuermoduls 50 aufweisen.

Auf der Modulleiterplatte 52 sind ferner weitere Komponenten 62 des Getriebesteuermoduls 50 angeordnet. Die Komponenten 62 können beispielsweise Sensoren, Stecker, Schnittstellen zum Ansteuern von Aktuatoren oder andere Bauelemente sein und mit der Modulleiterplatte 62 elektrisch verbunden sein.

Die Modulleiterplatte 52 ist mit einer Seite auf einer Getriebesteuermodulgrundplatte 56 angeordnet und fixiert. Beispielsweise kann die Modulleiterplatte 52 auf die Getriebesteuermodulgrundplatte 56 gelötet, geklebt und/oder geschweißt sein. Im Bereich der Ausnehmung 54 weist die Getriebesteuermodulgrundplatte 56 einen Metallboden 58 auf, auf welchem die Modulanordnung 10 mit der der Montageseite 13 entgegengesetzt angeordneten Seite vollflächig aufliegt und fixiert ist. Der Metallboden 58 kann als Kühlkörper für die Modulanordnung 10 dienen und zum Abführen von durch die Modulanordnung 10 generierte Wärme dienen. Auch die Modulanordnung 10 kann etwa auf die Getriebesteuermodulgrundplatte 56 gelötet, geklebt oder geschweißt sein. Die Kontaktpins 22 der Modulanordnung 10 sind mit auf der Modulleiterplatte 52 angeordneten Kontaktstellen 53 elektrisch leitfähig verbunden. Die Kontaktstellen 53 können etwa als Kontaktplättchen und/oder als Lötaugen ausgestaltet sein. Ein um den Metallboden 58 umlaufender und mit diesem verbundener Randbereich 60 der Getriebesteuermodulgrundplatte 56 kann aus Kunststoff gefertigt sein.

Weiter weist das Getriebesteuermodul 50 einen Schutzdeckel 64 auf, welcher die Modulanordnung 10 an einer der Getriebesteuermodulgrundplatte 56 gegenüberliegenden Seite vollständig umschließt und/oder überdeckt. Dazu ist der Schutzdeckel 64 auf einer Außenseite der Modulleiterplatte 52 dichtend befestigt. Der Schutzdeckel ist insbesondere dazu ausgeführt, die Modulanordnung 10 vor in einem Getriebe befindlichen Medien zu schützen.

Eine Montage der Modulanordnung 10 sowie des Getriebesteuermoduls 50 kann wie im Folgenden beschrieben vonstattengehen. Die Substratplatte 12 kann etwa in einem Elektronikwerk mit Bauelementen und insbesondere mit dem ungehäusten Halbleiterbauelement 16 bestückt werden. Davor oder danach kann der Kontaktrahmen 18 auf der Substratplatte 12 angebracht und etwa durch Löten befestigt werden. Vorzugsweise wird der Kontaktrahmen 18 vor einer Bestückung der Substratplatte 12 befestigt. Damit die noch unbestückte Substratplatte beim Anlöten des Kontaktrahmens 18 nicht beschädigt wird, kann dieser etwa durch Dampfphasenlöten, z.B. mit Galgen-Öl, befestigt werden, wobei Lötstellen aufgeschmolzen werden können, ohne die restliche Oberfläche der Montageseite 13 zu verunreinigen, etwa durch Oxidschichten, Verzunderung und/oder Ablagerungen. Alternativ kann der Kontaktrahmen 18 auch mit Leitkleber oder einem anderen geeigneten Verfahren befestigt werden. Wenn die Substratplatte 12 und die Modulleiterplatte 52 durch Bonddrähte verbunden werden sollen, sollten zugehörige Bondflächen auf der Substratplatte 12 bis zum Einbau in das Getriebesteuermodul 50 bzw. bis zur Montage des Schutzdeckels 64 geschützt werden. In diesem Fall kann der Kontaktrahmen 18 bzw. können zumindest die Kontaktpins 22 entfallen. Die Bondflächen für eine elektrische Verbindung zwischen der Modulanordnung 10 und der Modulleiterplatte 52 liegen vorzugsweise außerhalb des Kontaktrahmens 18, der dann nur noch eine Begrenzung für die Schutzmasse 20 darstellt. Anschließend kann die elektronische Schaltung 14 mit der Schutzmasse 20 vergossen und geschützt werden. Der Kontaktrahmen 18 dient dabei als Schutz, Berandung und/oder Einfassung der Schutzmasse 20, so dass diese nicht auf das von der Substratplatte 12 abragende Ende der Kontaktpins 22 gelangen und diese elektrische isolieren kann. Diese ungehäuste, aber gegen Feuchte und Partikel geschützte Modulanordnung 10 kann nun in einer kostengünstigen Transportverpackung in weltweitverteilte Modulwerke verschickt werden. Im Modulwerk werden die nur mit Schutzmasse 20 geschützten Modulanordnungen 10 der Transportverpackung entnommen und auf die Getriebesteuermodulgrundplatte 56 gesetzt und elektrisch kontaktiert, beispielsweise durch Bonden, Löten, Leitkleben, Kaltkontaktieren, Laserschweißen, Laserlöten und/oder Bügellöten. Derartige Verbindungs- bzw. Kontaktstellen können abschließend ebenfalls mit einer Schutzmasse, etwa einem Gel oder Lack, geschützt werden. In einem weiteren Fertigungsschritt kann der Schutzdeckel 64 aufgebracht und befestigt werden, etwa durch Kleben auf einen laserstrukturierten Bereich der Modulleiterplatte 52.

Abschließend ist darauf hinzuweisen, dass Begriffe wie "aufweisend", "umfassend", etc. keine anderen Elemente ausschließen und Begriffe wie "eine" oder "ein" keine Vielzahl ausschließen. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können. Bezugszeichen in den Ansprüchen sind nicht als Einschränkung anzusehen.

## Patentansprüche

1. Modulanordnung (10) für ein Getriebesteuermodul (50), aufweisend:
eine Substratplatte (12) mit einer elektronischen Schaltung (14);
wobei die elektronische Schaltung (14) auf einer Montageseite (13) der Substratplatte (12) angeordnet ist und wenigstens ein ungehäustes und mit Bonddrähten kontaktiertes Halbleiterbauelement (16) aufweist,
wobei die Modulanordnung (10) ferner einen Kontaktrahmen (18) aufweist, der die elektronische Schaltung (14) an der Montageseite (13) der Substratplatte (12) ringförmig umläuft,
wobei die elektronische Schaltung (14) und die Bonddrähte des Halbleiterbauelements (16) vollständig mit einer Schutzmasse (20) vergossen sind, wobei der die elektronische Schaltung (14) ringförmig umlaufende Kontaktrahmen (18) eine Einfassung (17) für die elektronische Schaltung (14) bereitstellt, und wobei ein von der Einfassung (17) umschlossener Bereich (19) der Montageseite (13) mit der Schutzmasse (20) soweit aufgefüllt ist, dass die Füllhöhe der Schutzmasse die Höhe des Kontaktrahmes (18) nicht übersteigt und dass ein Kontaktpin (22) zur elektrischen Kontaktierung der elektronischen Schaltung (14) seitlich von der Substratplatte (12) abragt, und **dadurch gekennzeichnet, dass** der Kontaktrahmen (18) mit der Montageseite (13) der Substratplatte (12) verlötet ist.

2. Modulanordnung (10) gemäß Anspruch 1, wobei die Schutzmasse (20) in einem ungehärteten Zustand ausreichend fließfähig ist, um freiliegende Bonddrähte schädigungsfrei zu umfließen.

3. Modulanordnung (10) gemäß einem der voranstehenden Ansprüche, wobei die Schutzmasse (20) ein Silikongel und/oder ein Schutzlack ist.

4. Modulanordnung (10) gemäß einem der voranstehenden Ansprüche, wobei die Schutzmasse (20) eine spezifische Dichte in einem Bereich von 0,5 g/cm³ bis 2 g/cm³ aufweist.

5. Modulanordnung (10) gemäß einem der voranstehenden Ansprüche, wobei die Schutzmasse (20) thermisch härtend ist

6. Modulanordnung (10) gemäß einem der voranstehenden Ansprüche,
wobei die Schutzmasse (20) in einem ungehärteten Zustand eine Viskosität von maximal 50 Pa s aufweist.

7. Modulanordnung (10) gemäß einem der voranstehenden Ansprüche,
wobei der Kontaktrahmen (18) ein Positionierelement (24) aufweist, welches an einer Seitenfläche (23) der Substratplatte (12) anliegt.

8. Modulanordnung (10) gemäß einem der voranstehenden Ansprüche,
wobei der Kontaktrahmen (18) wenigstens einen die elektronische Schaltung (14) zumindest bereichsweise überdeckenden Querriegel (30) aufweist, welcher an einer Seite (31) des Kontaktrahmens (18) angeordnet ist, die einer an der Montageseite (13) anliegenden Seite des Kontaktrahmens (18) entgegengesetzt angeordnet ist.

9. Getriebesteuermodul (50) mit einer Modulanordnung (10) gemäß einem der voranstehenden Ansprüche, welche in eine die Modulanordnung (10) umschließende Modulleiterplatte (52) integriert und mit der Modulleiterplatte (52) elektrisch verbunden ist.

10. Getriebesteuermodul (50) gemäß Anspruch 9,
wobei die Modulanordnung (10) mit einer der Montageseite (13) entgegengesetzt angeordneten Seite der Substratplatte (12) auf einer Getriebesteuermodulgrundplatte (56) fixiert ist, und
wobei das Getriebesteuermodul (50) einen Schutzdeckel (64) aufweist, welcher die Modulanordnung (10) an einer der Getriebesteuermodulgrundplatte (56) gegenüberliegenden Seite vollständig umschließt.

## Claims

1. Module assembly (10) for a transmission control module (50), having:
a substrate plate (12) with an electronic circuit (14) ;
the electronic circuit (14) being arranged on a mounting side (13) of the substrate plate (12) and having at least one semiconductor component (16) that is unhoused and contacted by bonding wires,
the module assembly (10) also having a contact frame (18), which runs around the electronic circuit (14) on the mounting side (13) of the substrate plate (12) in the manner of a ring,
the electronic circuit (14) and the bonding wires of the semiconductor component (16) being potted completely with a protective compound (20), the contact frame (18) running around the electronic circuit (14) in the manner of a ring providing a border (17) for the electronic circuit (14), and a region (19) of the mounting side (13) that is enclosed by the border (17) being filled with the protective compound (20) to such an extent that the filling level of the protective compound does not exceed the height of the contract frame (18) and that a contact pin (22) for making electric contact with the electronic circuit (14) projects laterally from the substrate plate (12), and
**characterized in that**
the contact frame (18) is soldered to the mounting side (13) of the substrate plate (12).

2. Module assembly (10) according to Claim 1,
wherein the protective compound (20) is sufficiently free-flowing in an uncured state to flow around exposed bonding wires without damage.

3. Module assembly (10) according to one of the preceding claims,
wherein the protective compound (20) is a silicone gel and/or a protective varnish.

4. Module assembly (10) according to one of the preceding claims,
wherein the protective compound (20) has a specific density in a range from 0.5 g/cm³ to 2 g/cm³.

5. Module assembly (10) according to one of the preceding claims,
wherein the protective compound (20) is thermosetting.

6. Module assembly (10) according to one of the preceding claims,
wherein the protective compound (20) has a viscosity of at most 50 Pa s in an uncured state.

7. Module assembly (10) according to one of the preceding claims,
wherein the contact frame (18) has a positioning element (24) which bears against a side surface (23) of the substrate plate (12).

8. Module assembly (10) according to one of the preceding claims,
wherein the contact frame (18) has at least one crossbar (30) which at least partly covers the electronic circuit (14) and is arranged on a side (31) of the contact frame (18) which is arranged opposite to a side of the contact frame (18) that rests on the mounting side (13).

9. Transmission control module (50) having a module assembly (10) according to one of the preceding claims, which is integrated into a module circuit board (52) enclosing the module assembly (10) and is connected electrically to the module circuit board (52).

10. Transmission control module (50) according to Claim 9,
wherein the module assembly (10) is fixed to a transmission control module base plate (56) by a side of the substrate plate (12) that is arranged opposite the mounting side (13), and
wherein the transmission control module (50) has a protective cover (64), which encloses the module assembly (10) completely on a side opposite to the transmission control module base plate (56).

## Revendications

1. Arrangement modulaire (10) pour un module de commande de boîte de vitesses (50), comprenant :
une plaque de substrat (12) dotée d'un circuit électronique (14) ;
le circuit électronique (14) étant disposé sur un côté de montage (13) de la plaque de substrat (12) et possédant au moins un composant semiconducteur (16) non mis en boîtier et mis en contact avec des fils de connexion,
l'arrangement modulaire (10) possédant en outre un cadre de contact (18) qui contourne le circuit électronique (14) en forme d'anneau au niveau du côté de montage (13) de la plaque de substrat (12),
le circuit électronique (14) et les fils de connexion du composant semiconducteur (16) étant entièrement scellés avec une masse de protection (20), le cadre de contact (18) qui contourne le circuit électronique (14) en forme d'anneau mettant à disposition une bordure (17) pour le circuit électronique (14),
et une zone (19) du côté de montage (13) entourée par la bordure (17) étant remplie avec la masse de protection (20) dans une mesure telle que la hauteur de remplissage par la masse de protection ne dépasse par la hauteur du cadre de contact (18) et qu'une broche de contact (22) destinée à établir le contact électrique avec le circuit électronique (14) fait saillie latéralement de la plaque de substrat (12),
et **caractérisé en ce que** le cadre de contact (18) est relié par brasage avec le côté de montage (13) de la plaque de substrat (12).

2. Arrangement modulaire (10) selon la revendication 1, la masse de protection (20) dans un état non durci étant suffisamment coulante pour s'écouler autour des fils de connexion dégagés sans les endommager.

3. Arrangement modulaire (10) selon l'une des revendications précédentes, la masse de protection (20) étant un gel de silicone et/ou un vernis protecteur.

4. Arrangement modulaire (10) selon l'une des revendications précédentes, la masse de protection (20) possédant une densité spécifique dans une plage de 0,5 g/cm³ à 2 g/cm³.

5. Arrangement modulaire (10) selon l'une des revendications précédentes, la masse de protection (20) étant thermodurcissante.

6. Arrangement modulaire (10) selon l'une des revendications précédentes, la masse de protection (20) dans un état non durci possédant une viscosité maximale de 50 Pas.

7. Arrangement modulaire (10) selon l'une des revendications précédentes, le cadre de contact (18) possédant un élément de positionnement (24) qui repose contre une surface latérale (23) de la plaque de substrat (12) .

8. Arrangement modulaire (10) selon l'une des revendications précédentes, le cadre de contact (18) possédant au moins une traverse (30) qui recouvre le circuit électronique (14) au moins dans certaines zones, laquelle est disposée au niveau d'un côté (31) du cadre de contact (18) qui est disposé à l'opposé d'un côté du cadre de contact (18) qui repose contre le côté de montage (13) .

9. Module de commande de boîte de vitesses (50) comprenant un arrangement modulaire (10) selon l'une des revendications précédentes, lequel est intégré dans un circuit imprimé modulaire (52) qui entoure l'arrangement modulaire (10) et est relié électriquement au circuit imprimé modulaire (52).

10. Module de commande de boîte de vitesses (50) selon la revendication 9,
l'arrangement modulaire (10) étant calé sur une plaque de base de module de commande de boîte de vitesses (56) avec un côté de la plaque de substrat (12) disposé à l'opposé du côté de montage (13), et
le module de commande de boîte de vitesses (50) possédant un couvercle de protection (64) qui entoure complètement l'arrangement modulaire (10) au niveau d'un côté à l'opposé de la plaque de base de module de commande de boîte de vitesses (56).
